(19) Europäisches Patentamt / European Patent Office / Office européen des brevets

(11) **EP 3 903 146 B1**

(12) **EUROPEAN PATENT SPECIFICATION**

(45) Date of publication and mention
of the grant of the patent:
**26.03.2025 Bulletin 2025/13**

(21) Application number: **19720594.1**

(22) Date of filing: **30.04.2019**

(51) International Patent Classification (IPC):
**G02F 1/025** (2006.01)    **G02F 1/225** (2006.01)

(52) Cooperative Patent Classification (CPC):
**G02F 1/025; G02F 1/225; H01S 5/0265;**
G02F 1/0155; G02F 1/212; H01S 5/12; H01S 5/50

(86) International application number:
**PCT/EP2019/061015**

(87) International publication number:
**WO 2020/221434 (05.11.2020 Gazette 2020/45)**

(54) **INTERFEROMETRIC ENHANCEMENT OF AN ELECTROABSORPTIVE MODULATED LASER**

INTERFEROMETRISCHE VERSTÄRKUNG EINES ELEKTROABSORPTIVEN MODULIERTEN LASERS

AMÉLIORATION INTERFÉROMÉTRIQUE D'UN LASER MODULÉ ÉLECTROABSORBANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**03.11.2021 Bulletin 2021/44**

(73) Proprietor: **Huawei Technologies Co., Ltd.
Longgang District,
Shenzhen, Guangdong 518129 (CN)**

(72) Inventor: **MOODIE, David
80992 Munich (DE)**

(74) Representative: **Pfenning, Meinig & Partner mbB
Patent- und Rechtsanwälte
Theresienhöhe 11a
80339 München (DE)**

(56) References cited:
**US-A1- 2008 074 722    US-A1- 2015 333 475
US-A1- 2017 195 058**

• **INUK KANG: "Phase-shift-keying and on-off
keying with improved performances using
electroabsorption modulators with
interferometric effects", OPTICS EXPRESS, OSA
PUBLISHING, US, vol. 15, no. 4, 19 February 2007
(2007-02-19), pages 1467 - 1473, XP002464101,
ISSN: 1094-4087, DOI: 10.1364/OE.15.001467**

EP 3 903 146 B1

**Description**

**BACKGROUND**

This invention relates to interferometric enhancement in optical transmitter devices, for example electroabsorptive modulated lasers (EMLs).

EMLs comprising monolithically integrated distributed feedback lasers (DFBs) and electroabsorption modulators (EAMs) are widely used in fibre optic transmission systems.

It has been shown that using electroabsorption modulators in a Mach-Zehnder (MZ) interferometric arrangement can result in several performance advantages. These include a higher extinction ratio for a given EAM electrode length and thus higher bandwidths for a given extinction ratio (as the electrode length may then be reduced), lower drive voltage and thus lower power consumption, and improved operating wavelength range.

However, previous implementations of EAMs in a MZ interferometer suffer from the disadvantages of increased optical loss (and thus lower output optical power) and significantly increased chip length.

In one previous example of an EAM-based interferometer, described in US 7,583,894, light is coupled into an EAM in a mixture of transverse electric (TE) and transverse magnetic (TM) polarization states which experience differing degrees of modulation. The TE and TM mode outputs from the EAM are passed through a polarizer after the EAM and by controlling the projection of the light onto the polarizer, controlled interference between light that passed through the EAM in TE and TM polarizations is achieved. It was also proposed to locate EAMs in each arm of a MZ interferometer. A disadvantage of sending TE and TM polarized light through an EAM and then passing the outputs through a polarizer is that such a scheme is difficult to integrate with a semiconductor laser in a monolithic chip.

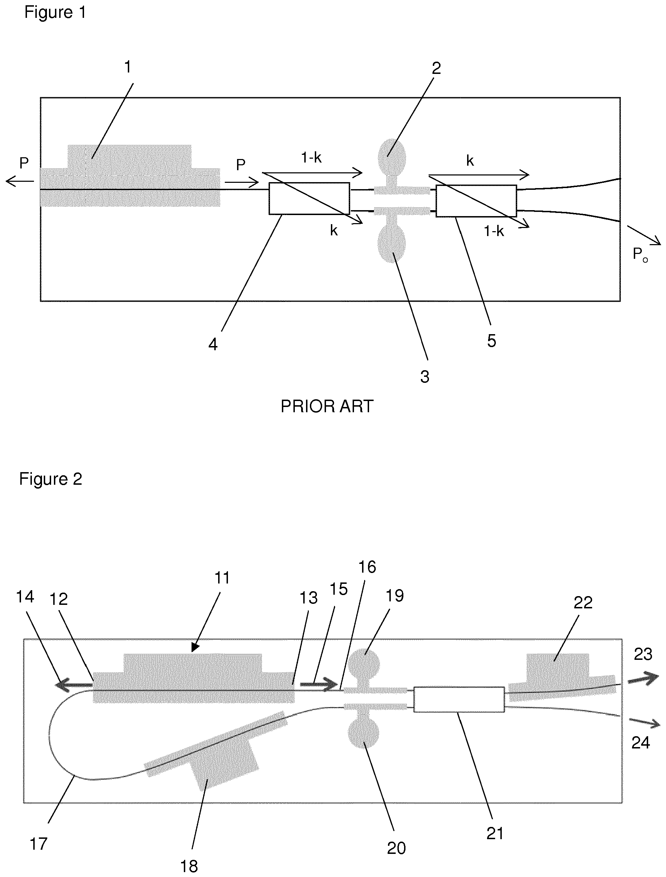

In another previous device, as described in Ueda et al, Optics Express, Vol. 22, No. 12, 2014, a low drive voltage modulator comprises an EAM and a DC phase shifter made from EAM material in a MZ interferometer with asymmetrical couplers at the input and output. Higher optical extinction ratios (ERs) for a given EAM length were achieved in the EAM MZ interferometer than with conventional EAMs. A further example, described in Ueda et al, JSTQE, Vol. 21, No. 6, 2015, uses separately optimized layers for the laser, the passive waveguide and the EAM and uses a symmetric λ/4 phase shifted DFB type laser. A schematic of this configuration is shown in Figure 1, with the DFB laser shown at 1, EAMs shown at 2 and 3 and optical couplers at 4 and 5. For these MZEAM and MZEA-DFB lasers, the presence of optical couplers before and after the EAM increases chip size compared to a conventional EAM or EML.

It is desirable to develop an improved way of integrating such components.

US 2015/333475 A1 discloses a monolithically integrated laser, also referred to as a U-laser, or integrated dual optical emission laser, having a first optical emission and a second optical emission where both the first and second optical emissions of the monolithically integrated laser are in optical communication with a modulator or other device is provided.

**SUMMARY OF THE INVENTION**

The present invention is set out in the appended set of claims. According to one aspect there is provided an optical transmitter comprising: a laser having a first end and a second end, the laser being capable of emitting light at both the first and the second end; an optical coupler having a first input, a second input and an output, the coupler being for coupling light received at both inputs into the output; a first optical path from the first end to the first input of the coupler, the first optical path comprising a modulator for modulating light passing along the first optical path; and a second optical path from the second end to the second input of the coupler wherein the two optical paths are configured such that the light received at both inputs of the coupler is substantially co-polarized.

The output of the coupler is an interferometric combination of the two optical inputs. By combining the outputs from both the first and second ends of the laser, the dynamic output power of the optical signal can be increased. Combining both outputs from the laser can reduce the chip size, as it removes the need for a second optical coupler. Furthermore, only one facet of the integrated device may be coated, rather than two facets in a conventional EML. This represents a cost saving.

The modulator is a first modulator and the second optical path comprises a second modulator for modulating light passing along the second optical path. Thus, the light travelling along each of the first and second paths may be independently modulated.

The second optical path comprises a phase shifter whereby the phase of light passing along the second optical path can be shifted. This may allow the light travelling along the second optical path, which has undergone a phase shift, to interfere constructively or destructively with the light from the first optical path when the paths are recoupled at the coupler.

The transmitter may comprise an input for receiving an electrical data signal, at least one of the first and second modulators being configured to modulate light passing along the respective optical path in dependence on the data signal.

At least one of the first and second optical paths may be curved or comprise a curved section. This may provide a suitable arrangement to allow the light travelling along the first and second optical paths to be received by the coupler.

At least one of the modulator and the second modulator may be an intensity modulator. At least one of the modulator and the second modulator may be an electroabsorption modulator. At least one of the modulator and the second modulator may be a phase modulator. The transmitter may therefore allow for various properties of the light signal to be modulated.

The laser may be a distributed feedback laser. DFB lasers may have good spectral stability and uniformity in key parameters.

The laser may be a symmetric $\lambda/4$ phase shifted laser. Such a laser results in approximately equal proportions of the generated light being emitted from opposing ends of the cavity.

The laser may be configured so that in operation its emission power at the first end is between 80% and 120% of its emission power at the second end. Emitting similar proportions of generated light at each end of the cavity avoids the effect of the random phase at a high reflectivity coated facet causing significant performance variation among chips fabricated from the same wafer.

The transmitter may comprise an optical amplifier for amplifying light passing from the output of the coupler. The transmitter may therefore be conveniently combined with other optical components.

The laser, the coupler, the first and second optical paths, the modulator and the second modulator may be defined in a common substrate. This may reduce the size and cost of the device.

The substrate may be a semiconductor substrate. Semiconductor substrates such as InP may be used. The optical transmitter may be arranged on a silicon wafer. This may allow the device to be conveniently integrated with other semiconductor components.

## BRIEF DESCRIPTION OF THE FIGURES

The present invention will now be described by way of example with reference to the accompanying drawings.

In the drawings:

Figure 1 shows a schematic plan view of a benchmark Mach-Zehnder interferometer with EAMs integrated with a DFB laser, as described in Ueda et al, JSTQE, Vol. 21, No. 6, 2015.

Figure 2 shows a schematic plan view of an exemplary embodiment of an optical transmitter according to the present invention.

Figures 3 shows a schematic plan view of a further exemplary embodiment of an optical transmitter.

Figure 4 shows a plot of the calculated output power of an example of the embodiment of Figure 3 when $V_{EAM1}$=Von (data 1) and $V_{EAM1}$=Voff (data 0) plotted against $\phi_{EAM2} + \phi_{PS}$.

Figure 5 shows a plot of the calculated output OMA and ER of an example of the embodiment of Figure 3 against $\phi_{EAM2} + \phi_{PS}$.

## DETAILED DESCRIPTION OF THE INVENTION

An arrangement of a monolithically integrated optical transmitter is shown in Figure 2. The device comprises a laser 11, which in this example is a distributed feedback (DFB) laser. The laser cavity has a front end 13 and a rear end 12 opposite to the front end. It is preferable that the front and rear ends are aligned parallel to one another.

The laser comprises an active layer (not shown) which may be interposed between layers of p- and n-type semiconductor material. In one example, the semiconductor layers are grown on an InP substrate. However, other semiconductor materials, such as GaAs, may be used. The material forming the laser may be selectively doped in the region of the p- and n-type layers. The laser may also comprise a waveguide structure. The waveguide may be a ridge waveguide. The ridge waveguide may be created by etching parallel trenches in the material either side of the ridge to create an isolated projecting strip, typically less than 5 $\mu$m wide and several hundred $\mu$m long. The ridge provides the lateral waveguiding, since the other layers in the ridge structure above the active layer have a higher index than the passivation layers (typically silica or some other dielectric material) in the etched channel regions.

The laser device has a common n electrode on one side of the cavity (not shown), which may be on the underside or substrate of the device, and another electrode connecting on the opposite side of the semiconductor junction. The application of a forward bias voltage to the electrodes of a section, such that the section acts as a gain section, causes light emission to be stimulated from that section of the cavity by applying a current across the electrodes.

Light is emitted from the end of the laser at the front end 13 of the laser device, shown at 15. Light is also emitted from the rear end 12 of the laser device, shown at 14.

The light signal from the front end 13 of the laser is directed along a first optical path 16. The light signal from the rear end 12 of the laser is directed along a second optical path 17. The second optical path 17 is curved. In one example, the second optical path may be formed by an etched mirror turn.

Along the second optical path 17 is a component 18 which acts as a phase shifter to adjust the phase of light passing along the second optical path. In the example of Figure 2, the phase shifter 18 is a thermal DC phase shifter.

The first optical path 16 comprises a first modulator 19. The second optical path 17 comprises a second modulator 20. In this example, the modulators 19 and 20 are electroabsorption modulators (EAMs).

The first and second optical paths are then recoupled by a coupler 21. The light travelling along the second optical path, which has undergone a phase shift, interferes constructively or destructively with the light from the first optical path when the paths are recoupled at the coupler 21. The coupler 21 generates a coherent superposition (sum) of the light received at the two inputs, i.e. an interferometric combination. The light received at both inputs of the coupler is considered to be substantially co-polarized if a polarization direction of the light received via the first optical path and a polarization direction of the light received via the second optical path differ from each other by less than 45 degrees. The polarization direction of light may be defined as the mean direction of the electrical field of the light. The angle between the two polarization directions may be called the polarization difference. The polarization difference between the light at the two inputs of the optical coupler is preferably less than 15 degrees, and more preferably less than 5 degrees. In one embodiment, the light emitted at the two ends of the laser is substantially co-polarized and the two optical paths do not substantially affect the polarization of the light; thus the light from the two ends of the laser will still be substantially co-polarized when it reaches the two inputs of the optical coupler.

Therefore, there is interferometric combination of the two outputs from the semiconductor laser after the light travelling along each path has passed through an optical modulator. The device therefore uses both outputs from a laser as optical inputs to the arms of the interferometer.

In the example of Figure 2, the device further comprises a semiconductor optical amplifier (SOA) 22 to amplify the modulated signal before the adjusted signal is output at 23. A second output from the coupler at 24 may be connected to a monitor, which could optionally be integrated onto the same chip as the device.

In the example of Figure 2, one of the EAMs may be used to impose data modulation to the light passing along its respective optical path. The other of the EAMs could either be used as a DC attenuator or a DC phase controller. Alternatively, the other of the EAMs could modulate the light passing along its respective optical path in antiphase to the signal modulated by the first modulator. If the EAM 20 along the second optical path 17 were used as a DC phase controller, the thermal DC phase shifter 18 would not be required. A phase shift may also be introduced along the second optical path by other means. For example, a 180 degree phase shift could be achieved by selecting suitable optical lengths of the first and second optical paths.

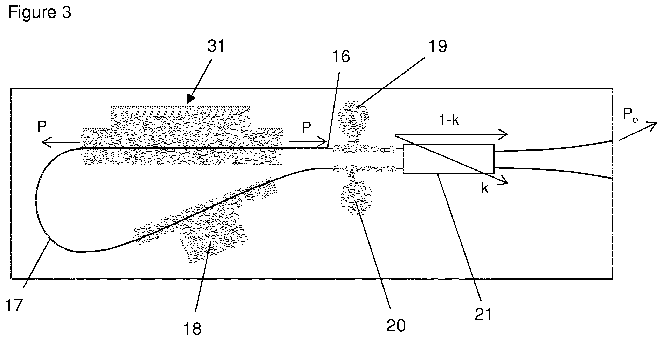

Another exemplary embodiment, the behavior of which is modelled below, is shown in Figure 3. Here, laser 31 is a symmetric $\lambda/4$ phase shifted DFB laser emitting equal optical powers (P) from each end of the laser cavity and having a high single mode yield. It is assumed that data modulation is applied only to the first EAM 19 (referred to below as EAM1) and in this case the second EAM 20 (referred to below as EAM2) has a DC bias voltage and is used to provide light of fixed phase and intensity for interference with the modulated light coming from the first EAM 19. In this example, there is no integrated SOA at the output. The output power $P_o$ is given by:

$$P_o=P\{(1-k)T_fT_{EAM1(V)}+kT_bT_{EAM2}+2k^{0.5}(1-k)^{0.5}T_f^{0.5}T_b^{0.5}T_{EAM1(V)}^{0.5}T_{EAM2}^{0.5}\cos(\phi_{EAM1(V)}-\phi_{EAM2}-\phi_{PS})\} \quad (1)$$

where P = optical power in the waveguide leaving either end of the DFB, k = optical power coupling coefficient of coupler, $T_{EAM1(V)}$ = optical transmission through EAM1 at bias voltage V, $T_{EAM2}$ = optical transmission through EAM2, $T_f$ = optical transmission from the front of the DFB (the waveguide leaving to the right of the DFB laser 31 in Figure 3) to the output facet excluding the EAM loss and coupler coupling loss, $T_b$ = optical transmission from the back of the DFB (the waveguide leaving to the left of the DFB laser 31 in Figure 3) to the output facet excluding the EAM loss and coupler coupling loss, $\phi_{EAM1(Voff)}$ = phase shift through EAM1 for data 0, $\phi_{EAM1(Von)}$ = phase shift through EAM1 for data 1, $\phi_{EAM2}$ = phase shift through EAM2, $\phi_{PS}$ = phase shift through thermal DC phase shifter.

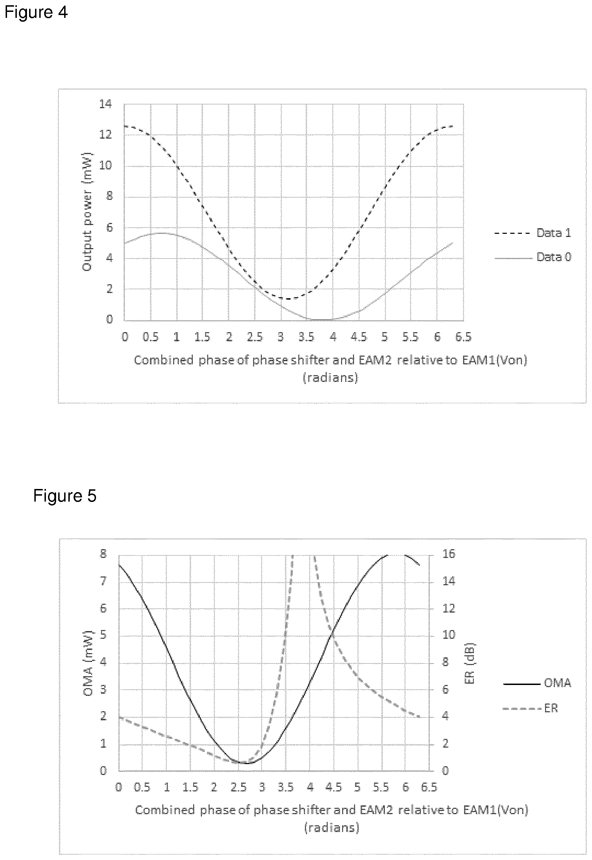

The results shown in Figures 4 and 5 are for a case when these parameters have the following values: P = 10 mW, $T_f$ = 0.9, $T_b$ = 0.7 (lower than $T_f$ to allow for some excess loss through the bend and longer waveguide path), $T_{EAM1(Von)}$ = 0.8, extinction ratio of EAM 1 = 6 dB (to allow for low drive voltage operation and low power consumption), $T_{EAM2}$ = 0.9, $\phi_{EAM1(Von)}$ = 0, $\phi_{EAM1(Voff)}$ = 0.69 radians (as EAMs typically have a small positive chirp parameter), k = 0.225 (chosen to allow a high ER at the output for the above parameters).

The variation in the calculated output power of this example embodiment when EAM1 is in the Von (data 1) and Voff (data 0) conditions versus the combined optical phase shift of the thermal DC phase shifter and EAM2 is shown in Figure 4. The corresponding ER and optical modulation amplitude (OMA) defined as the optical power difference between data 1 and data 0 are shown in Figure 5.

For a more conventional EML, with one EAM and no interferometer, based on the same DFB using EAM1 modulated to give a 6 dB modulation depth the corresponding OMA can be estimated using:

$$OMA_{EML} = P\ T_f\ (T_{EAM(Von)} - T_{EAM(Voff)}) \qquad (2)$$

Using the above values for P and $T_f$ (assuming the excess coupler loss only has a minor contribution to $T_f$) gives a benchmark value of $OMA_{EML}$ = 5.4 mW.

For the exemplary results shown in Figure 4, the relative phase of the two arms of the interferometer gives a degree of freedom to optimize parameters such as OMA and ER although in this case the optimum settings for these are offset. In this example the ER can exceed the 6 dB of the reference EML for $\phi_{EAM2} + \phi_{PS}$ between 3.3 and 5.3 radians and the OMA can exceed 5.4 mW of the reference EML for $\phi_{EAM2} + \phi_{PS}$ between 4.55 and $2\pi$ radians and between 0 and 0.8 radians. Thus, the region $4.55 < \phi_{EAM2} + \phi_{PS} < 5.3$ radians represents the range of phase offsets in this example where there is an improvement in both OMA and ER compared to the benchmark EML. For slightly lower values of the phase offset ($\phi_{EAM2} + \phi_{PS}$) significantly improved ER values can be achieved at the expense of a decrease in OMA.

If the phase shift in EAM1 ($\phi_{EAM1(Voff)} - \phi_{EAM1(von)}$) was higher than the +0.69 radians used in this example (corresponding to a larger positive chirp parameter in EAM1) then the relative phase offset of the two beams in the interferometer could be set to cause net destructive interference for a data 0 output state and net constructive interference for a data 1 state, thus relaxing the trade-off between ER and OMA described above.

A comparison of the expected value of $P_0$ for the MZ-EA DFB laser of the type shown in the prior art arrangement of Figure 1 can be performed. This comparison assumes that the laser used emits half of its light from each end of its cavity, as is the case for a symmetric $\lambda/4$ phase shifted DFB. For the configuration of Figure 1, in the case where EAM1 is modulated and EAM2 is only DC biased, the output power can be expressed by:

$$P_o=P\{(1-k)^2 T_f\ T_{EAM1(V)}+k^2 T_f\ T_{EAM2}+2k(1-k)T_f T_{EAM1(V)}^{0.5}T_{EAM2}^{0.5}\cos(\phi_{EAM1(V)} - \phi_{EAM2})\} \quad (3)$$

where the symbols represent the same parameters as above. Using the same values for P, $T_f$, $T_{EAM1(Von)}$, $T_{EAM1(Voff)}$, $T_{EAM2}$, $\phi_{EAM1(1)}$ and $\phi_{EAM1(0)}$ as were used in the calculation for the exemplary arrangement of Figure 3, approximately the same output ER values can be achieved if k for the couplers in the MZ-EA DFB is adjusted to 0.322. When the ER is set to be the same as in the embodiment of Figure 3, the calculated OMA for the prior art configuration is found to be approximately 2.3 dB lower. Therefore, provided that any additional optical losses associated with the longer arm of the interferometer of the embodiment of Figure 3 are kept sufficiently low, the proposed approach offers an improvement in OMA compared to the approach of the prior art.

The present invention therefore utilizes interferometric combination of two outputs from a semiconductor laser after one or both have passed through an optical modulator. Previous interferometric EAM/EML approaches couple light from one end of the semiconductor laser cavity into optical modulator(s) with the light from the other end being either used to couple into a monitor photodiode or wasted. Using outputs from both ends of the laser may result in lower optical loss and increase the dynamic optical output power, particularly if the laser is designed to emit approximately equal intensities from both ends. Using both outputs of a DFB means a phase shifted grating can be used to give a high yield. Combining both outputs from the laser can also reduce the chip size as it removes the need for a second optical coupler. Furthermore, only one facet of the integrated device may be coated, rather than two facets in a conventional EML. This represents a cost saving.

The described configuration is also suitable for on-wafer testing of the laser using the EAMs as photodiodes (PDs). As the laser does not require a reflective rear facet, the EAMs could be used as optical detectors to validate the laser on-wafer. If present, SOAs or monitor PDs could then validate the EAM performance on-wafer if required.

This approach also preserves the advantages of using EAMs in an interferometer of increasing the ER of a short high speed EAM by using destructive interference to reduce the intensity of the data zero. The trade-off between ER and drive voltage amplitude is also relaxed, so power consumption can be reduced. Using EAMs in an interferometer also reduces the wavelength dependence of modulation. As the wavelength dependence of the EAM can be a dominant factor limiting uncooled operation of EMLs, another advantage of using EAMs in an interferometer is that such EMLs could have better suitability for lower cost and lower power consumption for uncooled applications. The use of advanced modulation formats is also possible.

Furthermore, as the device monolithically integrates the laser with the phase shift component, the EAMs and the optical coupler, the device can therefore be defined on a single substrate, reducing the size of the device.

Alternative implementations of the present invention may include using phase modulators instead of EAMs. The invention may also be implemented with hybrid integrated devices or with optical devices connected optically using free space optics or fibres. The optical transmitter may be integrated with another optically functional structure. For example, the invention may be implemented by including one or more semiconductor optical amplifiers or monitor photodiodes, such as the SOA 22 shown in Figure 2. Different modulation formats may also be used. Furthermore, schemes may be used in which the modulators are modulated with data or RF signals received at the input of the device.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein, and without limitation to the scope of the claims. The applicant indicates that aspects of the present invention may consist of any such individual feature or combination of features. In view of the foregoing description it will be evident to a person skilled in the art that various modifications may be made within the scope of the invention.

**Claims**

1. An optical transmitter comprising:

   a laser (11) having a first end (12) and a second end (13), the laser being capable of emitting light at both the first and the second end;
   an optical coupler (21) having a first input, a second input and an output, the coupler being for coupling light received at both inputs into the output;
   a first optical path (16) from the first end (12) of the laser (11) to the first input of the coupler, the first optical path consisting of a first modulator (19) for modulating light passing along the first optical path; and
   a second optical path (17) from the second end (13) of the laser (11) to the second input of the coupler, the second optical path consisting of a phase shifter (18) whereby the phase of light passing along the second optical path can be shifted and a second modulator (20) for modulating light passing along the second optical path; wherein the two optical paths are configured such that the light received at both inputs of the coupler is substantially co-polarized, which represents that a polarization direction of the light received via the first optical path and a polarization direction of the light received via the second optical path differ from each other by less than 45 degrees.

2. An optical transmitter as claimed in claim 1, the transmitter comprising an input for receiving a data signal, at least one of the first and second modulators being configured to modulate light passing along the respective optical path in dependence on the data signal.

3. An optical transmitter as claimed in any preceding claim, wherein at least one of the first and second optical paths is curved or comprises a curved section.

4. An optical transmitter as claimed in any preceding claim, wherein at least one of the modulator and the second modulator is an intensity modulator.

5. An optical transmitter as claimed in claim 4, wherein at least one of the modulator and the second modulator is an electroabsorption modulator.

6. An optical transmitter as claimed in any preceding claim, wherein at least one of the modulator and the second modulator is a phase modulator.

7. An optical transmitter as claimed in any preceding claim, wherein the laser is a distributed feedback laser.

8. An optical transmitter as claimed in claim 7 wherein the laser is a symmetric $\lambda/4$ phase shifted laser.

9. An optical transmitter as claimed in any preceding claim, wherein the laser is configured so that in operation its emission power at the first end is between 80% and 120% of its emission power at the second end.

10. An optical transmitter as claimed in any preceding claim, wherein the transmitter comprises an optical amplifier for amplifying light passing from the output of the coupler.

11. An optical transmitter as claimed in any preceding claim, wherein the laser, the coupler, the first and second optical paths, the modulator and the second modulator are defined in a common substrate.

**12.** An optical transmitter as claimed in claim 11, wherein the substrate is a semiconductor substrate.

**13.** An optical transmitter as claimed in any preceding claim, wherein the optical transmitter is arranged on a silicon wafer.

**Patentansprüche**

**1.** Optischer Sender, umfassend:

einen Laser (11), der ein erstes Ende (12) und ein zweites Ende (13) aufweist, wobei der Laser sowohl an dem ersten als auch an dem zweiten Ende Licht emittieren kann;
einen optischen Koppler (21), der einen ersten Eingang, einen zweiten Eingang und einen Ausgang aufweist, wobei der Koppler zum Koppeln von an beiden Eingängen empfangenem Licht in den Ausgang dient;
einen ersten optischen Pfad (16) von dem ersten Ende (12) des Lasers (11) zu dem ersten Eingang des Kopplers, wobei der erste optische Pfad aus einem ersten Modulator (19) zum Modulieren von Licht, das entlang des ersten optischen Pfades hindurchtritt, besteht; und
einen zweiten optischen Pfad (17) von dem zweiten Ende (13) des Lasers (11) zu dem zweiten Eingang des Kopplers, wobei der zweite optische Pfad aus einem Phasenschieber (18), durch den die Phase von Licht, das entlang des zweiten optischen Pfades hindurchtritt, verschoben werden kann, und einem zweiten Modulator (20) zum Modulieren von Licht, das entlang des zweiten optischen Pfades hindurchtritt, besteht; wobei die beiden optischen Pfade derart konfiguriert sind, dass das Licht, das an den beiden Eingängen des Kopplers empfangen wird, im Wesentlichen kopolarisiert ist, was bedeutet, dass eine Polarisationsrichtung des Lichts, das über den ersten optischen Pfad empfangen wird, und eine Polarisationsrichtung des Lichts, das über den zweiten optischen Pfad empfangen wird, sich voneinander um weniger als 45 Grad unterscheiden.

**2.** Optischer Sender nach Anspruch 1, wobei der Sender einen Eingang zum Empfangen eines Datensignals aufweist, wobei mindestens einer des ersten und des zweiten Modulators dazu konfiguriert ist, Licht, das entlang des jeweiligen optischen Pfades hindurchtritt, in Abhängigkeit von dem Datensignal zu modulieren.

**3.** Optischer Sender nach einem der vorhergehenden Ansprüche, wobei mindestens einer des ersten und des zweiten optischen Pfades gekrümmt ist oder einen gekrümmten Abschnitt umfasst.

**4.** Optischer Sender nach einem der vorhergehenden Ansprüche, wobei mindestens einer des Modulators und des zweiten Modulators ein Intensitätsmodulator ist.

**5.** Optischer Sender nach Anspruch 4, wobei mindestens einer des Modulators und des zweiten Modulators ein Elektroabsorptionsmodulator ist.

**6.** Optischer Sender nach einem der vorhergehenden Ansprüche, wobei mindestens einer des Modulators und des zweiten Modulators ein Phasenmodulator ist.

**7.** Optischer Sender nach einem der vorhergehenden Ansprüche, wobei der Laser ein Laser mit verteilter Rückkopplung ist.

**8.** Optischer Sender nach Anspruch 7, wobei der Laser ein symmetrischer $\lambda/4$-phasenverschobener Laser ist.

**9.** Optischer Sender nach einem der vorhergehenden Ansprüche, wobei der Laser derart konfiguriert ist, dass im Betrieb seine Sendeleistung an dem ersten Ende zwischen 80% und 120% seiner Sendeleistung an dem zweiten Ende beträgt.

**10.** Optischer Sender nach einem der vorhergehenden Ansprüche, wobei der Sender einen optischen Verstärker zum Verstärken von Licht, das von dem Ausgang des Kopplers hindurchtritt, umfasst.

**11.** Optischer Sender nach einem der vorhergehenden Ansprüche, wobei der Laser, der Koppler, der erste und der zweite optische Pfad, der Modulator und der zweite Modulator in einem gemeinsamen Substrat definiert sind.

**12.** Optischer Sender nach Anspruch 11, wobei das Substrat ein Halbleitersubstrat ist.

13. Optischer Sender nach einem der vorhergehenden Ansprüche, wobei der optische Sender auf einem Siliziumwafer angeordnet ist.

**Revendications**

1. Émetteur optique comprenant :

   un laser (11) présentant une première extrémité (12) et une seconde extrémité (13), le laser étant capable d'émettre de la lumière à la fois au niveau de la première et de la seconde extrémité ;
   un coupleur optique (21) présentant une première entrée, une seconde entrée et une sortie, le coupleur étant destiné à coupler de la lumière reçue au niveau des deux entrées dans la sortie ;
   un premier chemin optique (16) allant de la première extrémité (12) du laser (11) à la première entrée du coupleur, le premier chemin optique étant constitué d'un premier modulateur (19) destiné à moduler de la lumière passant le long du premier chemin optique ; et
   un second trajet optique (17) allant de la seconde extrémité (13) du laser (11) à la seconde entrée du coupleur, le second trajet optique étant constitué d'un déphaseur (18) moyennant quoi la phase de lumière passant le long du second trajet optique peut être déphasée et d'un second modulateur (20) destiné à moduler de la lumière passant le long du second trajet optique ;
   dans lequel les deux trajets optiques sont configurés de telle sorte que la lumière reçue au niveau des deux entrées du coupleur soit sensiblement copolarisée, ce qui signifie qu'une direction de polarisation de la lumière reçue par l'intermédiaire du premier trajet optique et une direction de polarisation de la lumière reçue par l'intermédiaire du second trajet optique diffèrent l'une de l'autre de moins de 45 degrés.

2. Émetteur optique selon la revendication 1, l'émetteur comprenant une entrée destinée à recevoir un signal de données, au moins l'un des premier et second modulateurs étant configuré pour moduler de la lumière passant le long du trajet optique respectif en fonction du signal de données.

3. Émetteur optique selon une quelconque revendication précédente, dans lequel au moins l'un des premier et second chemins optiques est incurvé ou comprend une partie incurvée.

4. Émetteur optique selon une quelconque revendication précédente, dans lequel au moins l'un du modulateur et du second modulateur est un modulateur d'intensité.

5. Émetteur optique selon la revendication 4, dans lequel au moins l'un du modulateur et du second modulateur est un modulateur à électroabsorption.

6. Émetteur optique selon une quelconque revendication précédente, dans lequel au moins l'un du modulateur et du second modulateur est un modulateur de phase.

7. Émetteur optique selon une quelconque revendication précédente, dans lequel le laser est un laser à rétroaction distribuée.

8. Émetteur optique selon la revendication 7, dans lequel le laser est un laser symétrique à déphasage $\lambda/4$.

9. Émetteur optique selon une quelconque revendication précédente, dans lequel le laser est configuré de telle sorte qu'en fonctionnement, sa puissance d'émission au niveau de la première extrémité soit comprise entre 80 % et 120 % de sa puissance d'émission au niveau de la seconde extrémité.

10. Émetteur optique selon une quelconque revendication précédente, dans lequel l'émetteur comprend un amplificateur optique destiné à amplifier de la lumière passant par la sortie du coupleur.

11. Émetteur optique selon une quelconque revendication précédente, dans lequel le laser, le coupleur, les premier et second chemins optiques, le modulateur et le second modulateur sont définis dans un substrat commun.

12. Émetteur optique selon la revendication 11, dans lequel le substrat est un substrat semi-conducteur.

13. Émetteur optique selon une quelconque revendication précédente, dans lequel l'émetteur optique est disposé sur une plaquette de silicium.

Figure 1

1

P ← 

P →  1-k →

2

k →

k →

4

1-k →

P₀

5

3

PRIOR ART

Figure 2

14 12

11

13 15

16

19

22

23

17

18

20

21

24

Figure 3

Figure 4

Figure 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7583894 B

- US 2015333475 A1

**Non-patent literature cited in the description**

- **UEDA et al.** *Optics Express*, 2014, vol. 22 (12)

- **UEDA et al.** *JSTQE*, 2015, vol. 21 (6)